(19) Europäisches Patentamt
European Patent Office
Office européen des brevets

(11) Veröffentlichungsnummer : **0 384 366 B1**

(12) # EUROPÄISCHE PATENTSCHRIFT

(45) Veröffentlichungstag der Patentschrift : **15.02.95 Patentblatt 95/07**

(51) Int. Cl.$^6$ : **G03F 7/032,** G03F 7/027

(21) Anmeldenummer : **90103177.3**

(22) Anmeldetag : **20.02.90**

(54) **Lichtempfindliches Aufzeichnungselement.**

(30) Priorität : **24.02.89 DE 3905765**

(43) Veröffentlichungstag der Anmeldung : **29.08.90 Patentblatt 90/35**

(45) Bekanntmachung des Hinweises auf die Patenterteilung : **15.02.95 Patentblatt 95/07**

(84) Benannte Vertragsstaaten : **BE CH DE DK FR GB IT LI NL SE**

(56) Entgegenhaltungen :
**EP-A- 0 010 690**
**EP-A- 0 105 382**
**GB-A- 2 189 496**

(73) Patentinhaber : **BASF Aktiengesellschaft**
**Carl-Bosch-Strasse 38**
**D-67063 Ludwigshafen (DE)**

(72) Erfinder : **Huemmer, Wolfgang, Dr.**
**Vischerstrasse 16**
**D-6703 Limburgerhof (DE)**
Erfinder : **Dobler, Walter, Dr.**
**Feuerbachstrasse 17**
**D-6900 Heidelberg (DE)**
Erfinder : **Littmann, Dieter, Dr.**
**Neckarpromenade 36**
**D-6800 Mannheim 1 (DE)**



Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die vorliegende Erfindung betrifft ein neues lichtempfindliches Aufzeichnungselement für die Herstellung von Reliefdruckplatten und Photoresisten mit mindestens einer photopolymerisierbaren Aufzeichnungsschicht aus partiell oder nahezu vollständig hydrolysierten Poly(vinylalkoholalkancarbonsäureestern) und/oder partiell oder nahezu vollständig hydrolysierten Vinylalkoholalkancarbonsäureester-Alkylenoxid-Pfropfmischpolymerisaten, Photopolymerisationsinitiatoren, photopolymerisierbaren Monomeren und/oder photopolymerisierbaren olefinisch ungesättigten Resten, welche seitenständig und/oder endständig mit den vorstehend genannten Polymeren verknüpft sind, sowie mindestens zwei Hilfsstoffen.

Lichtempfindliche Aufzeichnungselemente der eingangs genannten Art sind seit langem bekannt. Für die Herstellung von Reliefdruckplatten oder von Photoresisten wird ihre photopolymerisierbare Aufzeichnungsschicht bildmäßig mit aktinischem Licht belichtet, wodurch die belichteten Bereiche photopolymerisiert werden und vernetzte, in den Entwicklerlösungsmitteln unlösliche Schichtbereiche ausbilden. Hiernach werden die unbelichteten Bereiche der bildmäßig belichteten Aufzeichnungsschicht mittels eines geeigneten Entwicklerlösungsmittels unter Erzeugung einer photopolymerisierten Reliefschicht ausgewaschen.

Aus den bekannten lichtempfindlichen Aufzeichnungselementen hergestellte Reliefschichten mit einer in der Druckindustrie üblichen Reliefstärke von etwa 1 µm bis 0,5 cm zeigen allerdings meist nicht die gewünschte scharfe Relieffeinstruktur und haben häufig zu flache Relief-Flankenwinkel, was auf eine vergleichsweise hohe Streuung des aktinischen Lichts in der photopolymerisierbaren Aufzeichnungsschicht während der bildmäßigen Belichtung zurückzuführen ist. Man hat bereits versucht, durch den Zusatz bestimmter, die Reliefstruktur verbessernder Hilfsstoffe zu den photopolymerisierbaren Aufzeichnungsschichten der bekannten lichtempfindlichen Aufzeichnungselemente diese Nachteile auszuräumen, zumindest aber zu verringern. Bekanntermaßen werden die Hilfstoffe, welche der Verbesserung der Reliefstruktur dienen, als "sensitometrische Regler" bezeichnet.

Einen deutlichen Fortschritt hat in diesem Zusammenhang die Verwendung der in der DE-A-32 48 247 empfohlenen Kombination aus 0,0001 bis 1 Gew.% eines Phenoxazinium-, Phenazinium-, Acridinium- oder Phenothiazinium-Farbstoffs und 0,005 bis 5 Gew.% eines milden Reduktionsmittels, das den betreffenden Farbstoff nur im angeregten Elektronenzustand zu reduzieren vermag, mit sich gebracht. Hierbei werden als milde Reduktionsmittel vorzugsweise Ascorbinsäure, Anethol, Thioharnstoff, Diethylallylthioharnstoff, N-Allylthioharnstoff, Salze des N-Nitrosocyclohexylhydroxylamins oder Hydrochinonmonomethylether verwendet. Ganz konkret gehen aus der DE-A-32 48 247 photopolymerisierbare Aufzeichnungsschichten der eingangs genannten Art hervor, welche den Farbstoff Safranin T (C.I. 50240) in Kombination mit N-Nitrosocyclohexylhydroxylamin im Gewichtsverhältnis 1:25, in Kombination mit Hydrochinonmonomethylether und Ascorbinsäure im Gewichtsverhältnis von 1:25 oder in Kombination mit Hydrochinonmonomethylether im Gewichtsverhältnis 1:15 enthalten.

Außerdem gehen aus der US-A-4 272 611 (EP-A-0 010 690) photopolymerisierbare Aufzeichnungsschichten der eingangs genannten Art hervor, welche den Farbstoff Eosin und N-Nitrosocyclohexylhydroxylamin im Gewichtsverhältnis von 1:10 oder von 1:20 enthalten.

Des weiteren gehen aus der EP-A-0 224 164 photopolymerisierbare Aufzeichnungsschichten der eingangs genannten Art hervor, welche den Farbstoff Duasyn Basisch Rot TM (C.I. 50240) in Kombination mit N-Nitrosocyclohexylhydroxylamin-Kaliumsalz im Gewichtsverhältnis von 1:13,3 enthalten. Ferner wird in der deutschen Patentanmeldung P 38 08 952.1 eine photopolymerisierbare Aufzeichnungsschicht der eingangs genannten Art beschrieben, welche die Farbstoffe Safranin T (C.I. 50240) und Kristallviolett (C.I. 42555) sowie N-Nitrosocyclohexylhydroxylamin im Gewichtsverhältnis von 1:5 enthält.

Allerdings werden die Farbstoffe bei der Entwicklung der bekannten bildmäßig belichteten photopolymerisierbaren Aufzeichnungsschichten der lichtempfindlichen Aufzeichnungselemente mit ausgewaschen und verfärben die gebrauchten Entwicklerlösungsmittel, was deren Wiederverwendung und/oder deren umweltgerechte Entsorgung zusätzlich erschwert. Darüber hinaus sind in den letzten Jahren die Ansprüche der Druck- und Elektroindustrie an die Qualität der mittels photopolymerisierbarer Aufzeichnungsschichten hergestellten Reliefdruckplatten und Photoresiste stetig gestiegen, was eine fortlaufende Weiterentwicklung der Methoden zur Reliefstrukturverbesserung erzwingt.

Es ist auch bereits bekannt, Verbindungen aus der Klasse der Isoalloxazine und der Alloxazine im Zusammenhang mit der Bilderzeugung mittels lichtempfindlicher Aufzeichnungselemente zu verwenden. Hierbei werden die Isoalloxazine oder die Alloxazine allerdings in Kombination mit einem milden Reduktionsmittel als Photopolymerisationsinitiatoren verwendet, welche gegenüber sichtbarem Licht empfindlich sind.

Photopolymerisationsinitiatoren dieser Art sind beispielsweise aus der US-A-3 556 794 bekannt. Als Beispiel für ein geeignetes Isoalloxazin wird Riboflavin angegeben. Als milde Reduktionsmittel werden aromatische oder aliphatische Sulfinsäuren sowie deren anorganischen Salze und organischen Ester,

Sulfinsäurehalogenide, Sulfinamide, Addukte von Sulfinsäuren und Carbonylverbindungen sowie Triaryl- und Trialkyl-substituierte Phosphine und Arsine verwendet. In der Gegenwart einer nitroaromatischen Carbonsäure oder derem Salz werden diese gegenüber sichtbarem Licht empfindlichen Photopolymerisationsinitiatoren durch Bestrahlen mit UV-Licht desaktiviert, wie insbesondere aus Beispiel 8, Spalte 26, Zeile 14, bis Spalte 27, Zeile 41, in Verbindung mit der Tabelle 7, Spalten 27 und 28, der US-A-3 556 794 hervorgeht.

Außerdem ist aus der japanischen Offenlegungsschrift JP-A-52/96 102 eine photopolymerisierbare Mischung bekannt, welche der Herstellung von Druckplatten dient. Diese photopolymerisierbare Mischung enthält ein Polymer mit Carboxylgruppen (Gantrez® AN-119 der GAF Corp., Copolymerisat aus Methylvinylether und Maleinsäureanhydrid), ein wasserlösliches Polymer wie z.B. Poly(ethylenoxid), photopolymerisierbare Monomere wie z.B. Methylenbis(acrylamid) und N-Methylolacrylamid und Hilfsstoffe wie z.B. p-Methoxyphenol. Als Photopolymerisationsinitiator enthält dieses photopolymerisierbare Gemisch eine Kombination des Natriumsalzes des Riboflavin-5′-Phosphats (Flavin Mononucleotid, FMN) mit Allylthioharnstoff.

Bei der aus der internationalen Patentanmeldung WO 83/3687 bekannten photopolymerisierbaren Mischung, welche Polymethylmethacrylat als Bindemittel enthält, wird ein Gemisch aus 1,3-Dipentylalloxazin und Triethylamin als Photopolymerisationsinitiator verwendet.

Aus der japanischen Offenlegungsschrift JP-A-60/165 647 geht eine photopolymerisierbare Mischung hervor, welche ein Bindemittel wie ein Butylmethacrylat-2-Ethylhexylmethacrylat-Methylmethacrylat-Methacrylsäure-Copolymerisat, ein photopolymerisierbares Monomer wie Tetraethylenglykoldiacrylat und Hilfsstoffe wie Hydrochinon und Farbstoffe wie z.B. Victoria-Reinblau enthält. Als Photopolymerisationsinitiator wird eine Kombination aus einer aromatischen Aminoverbindung wie 4-Dimethylaminobenzoin und einem Isoalloxazin wie Riboflavin-tetrabutyrat (RFTB) verwendet.

Eine hiermit vergleichbare photopolymerisierbare Mischung, welche gegenüber sichtbarem Licht ganz besonders empfindlich ist, geht aus der japanischen Offenlegungsschrift JP-A-60/57 832 hervor. Hierin wird anstelle der vorstehend genannten aromatischen Aminoverbindungen Aminobenzoesäurederivate wie p-Dimethylaminobenzoesäureisoamylester verwendet.

Auch das aus der japanischen Offenlegungsschrift JP-A-61/725 138 bekannte photopolymerisierbare Gemisch gleicht weitgehend dem aus der vorstehend genannten japanischen Offenlegungsschrift JP-A-60/165 647 bekannten und ist gleichfalls ganz besonders empfindlich gegenüber sichtbarem Licht.

Auch in der photopolymerisierbaren Mischung der japanischen Offenlegungsschrift JP-A-62/156 103, welche ein Ethylacrylat-Methacrylsäure-Methylmethacrylat-Copolymerisat als Bindemittel, Pentaerythritoltriacrylat als photopolymerisierbares Monomer sowie Hydrochinonmonomethylether und Victoria-Reinblau als Hilfsstoffe enthält, wird eine Kombination aus einem Isoalloxazinderivat wie Riboflavin-tetrabutyrat (RFTB) und einem weiteren Coinitiator als Photopolymerisationsinitiator für sichtbares Licht verwendet. Im Unterschied zu den vorstehend beschriebenen Patentschriften wird hierin als Coinitiator ein organisches Peroxid verwendet.

Darüber hinaus geht aus der japanischen Offenlegungsschrift JP-A-62/123 450 eine photopolymerisierbare Mischung hervor, welche mit den vorstehend beschriebenen vergleichbar ist, worin indes als Coinitiator eine N-Arylaminosäure wie N-Phenylglycin verwendet wird.

All diesen bekannten Isoalloxazin- oder Alloxazinderivaten enthaltenden Photopolymerisationsinitiatoren ist gemeinsam, daß sie ausgesprochen empfindlich gegenüber sichtbarem Licht sind.

Dem Stand der Technik sind keine Hinweise zu entnehmen, die dazu anregen könnten, Verbindungen aus den Klassen der Isoalloxazine und der Alloxazine zusammen mit speziell ausgewählten milden Reduktionsmitteln in photopolymerisierbaren Aufzeichnungsschichten, welche partiell oder nahezu vollständig hydrolysierte Poly(vinylalkoholalkancarbonsäureester) und/oder partiell oder nahezu vollständig hydrolysierte Vinylalkoholalkancarbonsäureester-Alkylenoxid-Pfropfmischpolymerisate als Bindemittel enthalten, zum Zwecke der Reliefstrukturverbesserung, d.h. als Hilfsmittelkombination bzw. als sensitometrischen Regler, zu verwenden. Im Gegenteil läßt ihre vorzügliche Wirkung als Photopolymerisationsinitiatoren bei der Bestrahlung mit sichtbarem Licht befürchten, daß ihre Verwendung in den besagten photopolymerisierbaren Aufzeichnungsschichten keinen nützlichen technischen Effekt, sondern in der Praxis eher Nachteile, insbesondere bei der Handhabung, mit sich bringt.

Aufgabe der vorliegenden Erfindung ist es, ein neues lichtempfindliches Aufzeichnungselement mit mindestens einer photopolymerisierbaren Aufzeichnungsschicht aus mindestens einem partiell oder nahezu vollständig hydrolysierten Poly(vinylalkoholalkancarbonsäureester) und/oder mindestens einem partiell oder nahezu vollständig hydrolysierten Vinylalkoholalkancarbonsäureester-Alkylenoxid-Pfropfmischpolymerisat als Bindemittel, mindestens einer photopolymerisierbaren olefinisch ungesättigten Verbindung (Monomer), welche mit dem Bindemittel verträglich ist, und/oder photopolymerisierbaren olefinisch ungesättigten Resten, welche seitenständig und/oder endständig mit den Bindemitteln verknüpft sind, und mindestens zwei Hilfsstoffen aufzuzeigen, welches die Herstellung von Reliefdruckplatten und Photoresisten mit gut ausgeprägter Reliefstruktur auch bei sehr feinen Bildelementen vorlagengetreu gestattet.

Außerdem soll das neue lichtempfindliche Aufzeichnungselement die Nachteile des Standes der Technik nicht mehr länger aufweisen und es soll insbesondere nach seiner bildmäßigen Belichtung mit kurzwelligem aktinischem Licht und seiner Entwicklung mit einem geeigneten Entwicklerlösungsmittel zu Reliefdruckplatten und Photoresisten mit verbesserter Reliefstruktur führen.

Überraschenderweise konnte diese Aufgabe durch ein lichtempfindliches Aufzeichnungselement mit mindestens einer photopolymerisierbaren Aufzeichnungsschicht der in Rede stehenden Art gelöst werden, welches in seiner photopolymerisierbaren Aufzeichnungsschicht zumindest eine Hilfsstoffkombination aus mindestens zwei Hilfsstoffen der nachfolgend näher beschriebenen Art als sensitometrischen Regler enthält.

Gegenstand der Erfindung ist dementsprechend ein neues lichtempfindliches Aufzeichnungselement für die Herstellung von Reliefdruckplatten oder Photoresisten mit

A) einem dimensionsstabilen Träger und mit

B) mindestens einer photopolymerisierbaren Aufzeichnungsschicht aus

$b_1$) mindestens einem partiell oder nahezu vollständig hydrolysierten Poly(vinylalkoholalkancarbonsäureester) und/oder mindestens einem partiell oder nahezu vollständig hydrolysierten Vinylalkoholalkancarbonsäureester-Alkylenoxid-Pfropfmischpolymerisat als Bindemittel,

$b_2$) mindestens einem Photopolymerisationsinitiator, welcher beim Bestrahlen mit kurzwelligem aktinischem Licht Radikale liefert, die die Photopolymerisation initiieren,

$b_3$) mindestens einer photopolymerisierbaren olefinisch ungesättigten Verbindung (Monomer), welche mit dem Bindemittel ($b_1$) verträglich ist, und/oder photopolymerisierbaren olefinisch ungesättigten Resten, welche seitenständig und/oder endständig mit dem Bindemittel ($b_1$) verknüpft sind, und

$b_4$) mindestens zwei Hilfsstoffen,

welches dadurch gekennzeichnet ist, daß seine photopolymerisierbare Aufzeichnungsschicht (B) als Hilfsstoffe $b_4$) zumindest den sensitometrischen Regler ($b_4$) aus

$b_{41}$) mindestens einer Verbindung aus der Klasse der Isoalloxazine und/oder aus der Klasse der Alloxazine und

$b_{42}$) N-Nitrosocyclohexylhydroxylamin-Kaliumsalz, N-Nitrosodiphenylamin und/oder Hydrochinonmonomethylether

in einer Menge von 0,01 bis 6 Gew.%, bezogen auf die photopolymerisierbare Aufzeichnungsschicht (B), enthält, wobei das Gewichtsverhältnis ($b_{41}$):($b_{42}$) bei 1:2 bis 1:1000 liegt.

Im Rahmen der vorliegenden Erfindung zeigt der Begriff "verträglich" generell an, daß der betreffende Bestandteil in der photopolymerisierbaren Aufzeichnungsschicht (B) molekulardispers und/oder ohne Trübung oder Schlieren hierin hervorzurufen verteilt werden kann und sich auch im Laufe der Zeit hieraus nicht entmischt.

Unter "Hilfsstoffen" sind hier Verbindungen zu verstehen, mit denen ganz allgemein eine Variation - üblicherweise eine Verbesserung - anwendungstechnischer Eigenschaften lichtempfindlicher Aufzeichnungsschichten, insbesondere photopolymerisierbarer Aufzeichnungsschichten (B), erreicht wird. Diese Verbesserungen manifestieren sich vor allem in Reliefdruckplatten und Photoresisten, welche man unter Verwendung der lichtempfindlichen Aufzeichnungsschichten, die diese Hilfsstoffe enthalten, hergestellt hat.

Das erfindungsgemäße neue lichtempfindliche Aufzeichnungselement für die Herstellung von Reliefdruckplatten oder Photoresisten, welches mindestens eine photopolymerisierbare Aufzeichnungsschicht (B) aufweist, wird im folgenden der Kürze halber als "erfindungsgemäßes Aufzeichnungselement" bezeichnet.

Der wesentliche Bestand des erfindungsgemäßen Aufzeichnungselements ist seine neue photopolymerisierbare Aufzeichnungsschicht (B).

Der erfindungsgemäß wesentliche Bestandteil der neuen photopolymerisierbaren Aufzeichnungsschicht (B) ist der sensitometrische Regler ($b_4$).

Der erfindungsgemäß zu verwendende sensitometrische Regler ($b_4$) besteht aus mindestens einem der Hilfsstoffe ($b_{41}$) und aus mindestens einem der Hilfsstoffe ($b_{42}$).

Bei den erfindungsgemäß zu verwendenden Hilfsstoffen ($b_{41}$) handelt es sich um Verbindungen aus der Klasse der Isoalloxazine oder aus der Klasse der Alloxazine. Hierbei enthält der sensitometrische Regler ($b_4$) entweder mindestens eine Verbindung aus der Klasse der Isoalloxazine oder mindestens eine Verbindung aus der Klasse der Alloxazine. Selbstverständlich kann der sensitometrische Regler ($b_4$) auch mindestens eine Verbindung aus der Klasse der Isoalloxazine und mindestens eine Verbindung aus der Klasse der Alloxazine enthalten.

Beispiele erfindungsgemäß geeigneter Verbindungen aus den Klassen der Alloxazine und der Isoalloxazine sind Alloxazin, in 3-, 5-, 6-, 7-, 8- und/oder 9-Stellung mit Alkylresten mono-, di-, tri-, tetra-, penta- oder hexasubstituierte Alloxazine und Isoalloxazine, worin Alkyl für Methyl, Ethyl, n-Propyl, i-Propyl, n-Butyl, n-Pentyl, n-Hexyl, n-Heptyl, n-Octyl, n-Nonyl, n-Decyl, n-Undecyl, n-Dodecyl, n-Tridecyl, n-Tetradecyl, n-Heptadecyl, n-Hexadecyl, n-Heptadecyl, n-Octadecyl, n-Nonadecyl oder n-Eicosanyl steht, 6,7-Dimethyl-9-(D-1′-ribityl)-flavin (Riboflavin, RF), Riboflavin-5′-phosphat (Flavinmononucleotid, FMN), Riboflavin-Tetraester wie das Tetraacetat, Tetrapropionat, Tetrabutyrat und das Tetravaleriat, von denen Alloxazin, 7,8-Dimethylalloxazin, 7,8,9-Trimethylisoalloxazin, Riboflavin (RF), Riboflavin-tetrabutyrat (RFTB), das Flavinmononucleotid (FMN) und dessen Natriumsalz besonders gut geeignet sind.

Der erfindungsgemäß zu verwendende sensitometrische Regler ($b_4$) enthält mindestens einen Hilfsstoff ($b_{42}$). Hierbei handelt es sich um die speziell ausgewählten milden Reduktionsmittel N-Nitrosocyclohexylhydroxylamin-Kaliumsalz, N-Nitrosodiphenylamin und um Hydrochinonmonomethylether. Von diesen drei Verbindungen ist mindestens eine in dem sensitometrischen Regler ($b_4$) enthalten.

In dem erfindungsgemäß zu verwendenden sensitometrischen Regler ($b_4$) liegt das Gewichtsverhältnis der Hilfsstoffe ($b_{41}$):($b_{42}$) bei 1:2 bis 1:1000. Hierbei empfiehlt es sich im allgemeinen nicht, den Anteil der Hilfsstoffe ($b_{41}$) soweit zu erhöhen, daß Gewichtsverhältnisse ($b_{41}$):($b_{42}$) resultieren, welche größer sind als 1:2, weil ansonsten die durch den sensitometrischen Regler hervorgerufenen technischen Effekte nicht immer den Ansprüchen der Praxis in vollem Umfang gerecht werden. Das gleiche gilt, wenn das Gewichtsverhältnis ($b_{41}$):($b_{42}$) kleiner als 1:1000 gewählt wird.

Demgemäß handelt es sich bei dem Bereich für die Gewichtsverhältnisse ($b_{41}$):($b_{42}$) von 1:2 bis 1:1000 um ein Optimum, innerhalb dessen das Gewichtsverhältnis der Hilfsstoffe ($b_{41}$) und ($b_{42}$) in vorteilhafter Weise variiert und der jeweils verwendeten photopolymerisierbaren Aufzeichnungsschicht (B) angepaßt werden kann. Innerhalb dieses optimalen Bereiches sind die Gewichtsverhältnisse ($b_{41}$):($b_{42}$) hervorzuheben, welche bei 1:10 bis 1:100, insbesondere bei 1:10 bis 1:50 liegen, weil aus solchen Gewichtsverhältnissen ($b_{41}$):($b_{42}$) ein ganz besonders vorteilhaftes anwendungstechnisches Eigenschaftsprofil der betreffenden neuen photopolymerisierbaren Aufzeichnungsschicht (B) resultiert. Dies bedeutet, daß sensitometrische Regler ($b_4$), deren Hilfsstoffe ($b_{41}$) und ($b_{42}$) ein solches Gewichtsverhältnis haben, einen besonders vorteilhaften technischen Effekt hervorrufen und daher erfindungsgemäß ganz besonders bevorzugt sind.

Unabhängig davon, in welchem Gewichtsverhältnis die Hilfsstoffe ($b_{41}$) und ($b_{42}$) in dem erfindungsgemäß zu verwendenden sensitometrischen Regler ($b_4$) zueinander stehen, ist der sensitometrische Regler ($b_4$) in der neuen photopolymerisierbaren Aufzeichnungsschicht (B) stets in einer Menge von 0,01 bis 6 Gew.% enthalten. Hierbei empfiehlt es sich im allgemeinen nicht, den Anteil des sensitometrischen Reglers ($b_4$) in der neuen photopolymerisierbaren Aufzeichnungsschicht (B) über 6 Gew.% hinaus zu erhöhen, weil es hierbei unter gewissen Umständen zu unerwünschten Nebenreaktionen in der neuen photopolymerisierbaren Aufzeichnungsschicht (B), bei deren Lagerung, Handhabung und/oder bei oder nach deren bildmäßigen Belichtung kommen kann. Dagegen soll im allgemeinen der Anteil des sensitometrischen Reglers ($b_4$) an der neuen photopolymerisierbaren Aufzeichnungsschicht (B) 0,01 Gew.% nicht unterschreiten, weil hiernach die durch den sensitometrischen Regler ($b_4$) hervorgerufenen technischen Effekte nicht immer den Ansprüchen der Praxis in vollem Umfang gerecht werden.

Demgemäß handelt es sich bei dem Bereich von 0,01 bis 6 Gew.% um ein Optimum, innerhalb dessen der Anteil des sensitometrischen Reglers ($b_4$) an der neuen photopolymerisierbaren Aufzeichnungsschicht (B) mit Vorteil variiert und der jeweils verwendeten neuen photopolymerisierbaren Aufzeichnungsschicht (B) angepaßt werden kann. Innerhalb dieses optimalen Bereichs ist derjenige von 0,03 bis 4 Gew.% bevorzugt, weil neue photopolymerisierbare Aufzeichnungsschichten (B) mit einem solchen Gehalt an sensitometrischem Regler ($b_4$) besonders vorteilhaft sind und Reliefschichten (B′) mit ausgezeichneter Reliefstruktur liefern.

Aus diesem erfindungsgemäß bevorzugten Bereich ist wiederum derjenige von 0,1 bis 1 Gew.% hervorzuheben, weil aus einem solchen Anteil an sensitometrischem Regler ($b_4$) ein ganz besonders vorteilhaftes anwendungstechnisches Eigenschaftsprofil der betreffenden neuen photopolymerisierbaren Aufzeichnungsschicht (B) resultiert. Dies bedeutet, daß dieser Anteil an sensitometrischem Regler ($b_4$) hinsichtlich des Materialaufwandes einerseits und des hiermit erzielten technischen Effekts andererseits hervorragend ausgewogen und daher erfindungsgemäß ganz besonders bevorzugt ist.

Die neue photopolymerisierbare Aufzeichnungsschicht (B) enthält, bezogen auf ihre Gesamtmenge, 10 bis 99, vorzugsweise 20 bis 80 und insbesondere 30 bis 70 Gew.% mindestens eines partiell oder nahezu vollständig hydrolysierten Poly(vinylalkoholalkancarbonsäureesters) und/oder mindestens eines partiell oder nahezu vollständig hydrolysierten Vinylalkoholalkancarbonsäurrester-Alkylenoxid-Pfropfmischpolymerisats als Bindemittel ($b_1$). Demgemäß kann die neue photopolymerisierbare Aufzeichnungsschicht (B) entweder eines der, mehrere oder alle Bindemittel ($b_1$) der vorstehend genannten Art enthalten.

Beispiele gut geeigneter Bindemittel ($b_1$) sind hierbei die bekannten in Wasser löslichen oder dispergierbaren hydrolysierten Poly(vinylalkoholalkancarbonsäureester), welche wiederkehrende 1-Hydroxy-ethyliden-1,2-Einheiten

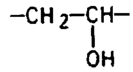

in der Polymerkette enthalten, zahlenmittlere Molekulargewichte $\overline{M}_n$ von $10^4$ bis $10^5$, insbesondere $1{,}5 \cdot 10^4$ bis $5 \cdot 10^4$ aufweisen und einen Hydrolysegrad von 60 bis 99,99, vorzugsweise 70 bis 99 und insbesondere 75 bis 95 % haben. Von diesen sind partiell oder nahezu vollständig hydrolysiertes Polyvinylacetat oder -propionat besonders gut geeignet. Sie werden im allgemeinen auch als Polyvinylalkohole bezeichnet.

Weitere Beispiele gut geeigneter Bindemittel ($b_1$) sind partiell oder nahezu vollständig hydrolysierten Vinylalkoholalkancarbonsäureester-Alkylenoxid-Pfropfmischpolymerisate, welche durch Pfropfen von Vinylacetat oder Vinylpropionat auf Polyethylenoxid und anschließende Hydrolyse erhalten werden und aus - jeweils bezogen auf das Pfropfmischpolymerisat - 10 bis 30 Gew.% an 1-Oxapropyliden-1,3-Einheiten,

$$-CH_2-CH_2-O-$$

0,01 bis 30 Gew.% an 1-Acetyl- oder 1-Propionyl-ethyliden-1,2-Einheiten

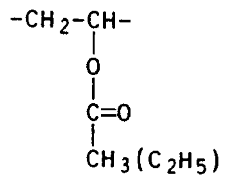

und 89,99 bis 40 Gew.% an 1-Hydroxy-ethyliden-1,2-Einheiten bestehen. Pfropfmischpolymerisate dieser Art sind beispielsweise aus der EP-A-0 010 690 oder der EP-A-0 224 164 bekannt.

Sowohl die vorstehend genannten Polyvinylalkohole als auch die hydrolysierten Vinylalkoholalkancarbonsäureester-Alkylenoxid-Pfropfmischpolymerisate, können photopolymerisierbare olefinisch ungesättigte Reste ($b_3$) enthalten, welche seitenständig und/oder endständig mit den betreffenden Polymerketten verknüpft sind. Bei diesen photopolymerisierbaren olefinisch ungesättigten Resten ($b_3$) handelt es sich um seitenständige Alkencarbonsäurereste, wie Acryl-, Methacryl- oder Maleinsäurereste; oder um Alkencarbonylamino-N-methylenetherreste wie Acryl- oder Methacrylamido-N-methylenetherreste. Diese photopolymerisierbaren olefinisch ungesättigten Reste ($b_3$) können durch die üblichen und bekannten polymeranalogen Umsetzungen der betreffenden Anhydride oder der betreffenden methylolierten Alkencarbonsäureamide mit den Polyvinylalkoholen oder den hydrolysierten Vinylalkoholalkancarbonsäureester-Alkylenoxid-Pfropfmischpolymerisaten hergestellt werden. Üblicherweise werden hierbei 0,1 bis 10, vorzugsweise 0,5 bis 8 und insbesondere 1 bis 6 Mol.% der in den betreffenden Polymerisaten enthaltenen Hydroxylgruppen umgesetzt.

Die in der vorstehend beschriebenen Weise mit den Bindemitteln ($b_1$) verknüpften photopolymerisierbaren olefinisch ungesättigten Reste ($b_3$) können die alleinigen photopolymerisierbaren Bestandteile der neuen photopolymerisierbaren Aufzeichnungsschicht (B) sein. Die neue photopolymerisierbare Aufzeichnungsschicht (B) kann indes noch mindestens eine photopolymerisierbare olefinisch ungesättigte Verbindung (Monomer) ($b_3$) enthalten. Hierbei ist es von Vorteil, wenn in der neue photopolymerisierbaren Aufzeichnungsschicht (B) mindestens ein solches Monomer ($b_3$) enthalten ist. In diesem Falle kann auf die Mitverwendung der photopolymerisierbaren olefinisch ungesättigten Reste ($b_3$) verzichtet werden.

Gut geeignete Monomere ($b_3$) sind mit dem Bindemittel ($b_1$) verträglich. Im allgemeinen weisen sie einen Siedepunkt von über 100°C auf. Üblicherweise haben sie ein Molekulargewicht von weniger als 3000, vorzugsweise von weniger als 2000.

Beispiele für gut geeignete Monomere ($b_3$) sind die Ester der Acrylsäure und/oder Methacrylsäure mit ein- oder mehrwertigen Alkoholen wie z.B. Butylacrylat, Butylmethacrylat, 2-Ethylhexylacrylat, Laurylacrylat, Laurylmethacrylat, Ethylenglykoldi(meth)acrylat, Butandiol-1,4-di(meth)acrylat, Neopentylglykol-di(meth)acrylat, 3-Methylpentandiol-di(meth)acrylat, 2-Hydroxypropyl(meth)acrylat, 2-Hydroxyethyl-(meth)acrylat, Hexandiol-1,6-di(meth)acrylat, 1,1,1-Trimethylolpropan-tri(meth)acrylat, Di-, Tri- und Tetraethylenglykoldi(meth)acrylat, 3,12-Dihydroxy-1,5,10,14-tetraoxatetradec-1,14-diyl-di(meth)acrylat, 2-Hydroxy-3-phenoxypropyl(meth)acrylat und Ethylenglykol-, Diethylenglykol-, Triethylenglykol-, Tetraethylenglykol-, Propylenglykol-, Dipropylenglykol-, Butan-1,4-diol-, Pentan-1,5-diol- und Hexan-1,6-diol-diglycidyletherdi(meth)acrylat. Weitere Beispiele für gut geeignete Monomere ($b_3$) sind Vinylester aliphatischer Monocarbonsäure wie Vinyloleat; Divinylether von Alkoholen wie Octadecylvinylether und Butandiol-1,4-divinylether; die Diester von Fumar- und Maleinsäure; oder die Umsetzungsprodukte aus OH-terminierten Oligobutadienen mit Maleinsäure und/oder mit Acrylsäure; die Alkencarbonylamino-N-methylenether wie Ethylenglykol-bis-, Propandiol-bis-, Butandiol-bis-, Diethylenglykol-bis-, Glycerol-bis-, Glycerol-tris- oder

Pentaerythritol-tetrakis-(methacrylamido-N-methylenether) sowie die entsprechenden Acrylamido-N-methylenether.

Wenn die Monomeren ($b_3$) verwendet werden, sind sie in der neuen photopolymerisierbaren Aufzeichnungsschicht (B) in einer Menge von 10 bis 70, vorzugsweise 20 bis 60 und insbesondere 25 bis 55 Gew.% enthalten.

Ein weiterer wesentlicher Bestandteil der neuen photopolymerisierbaren Aufzeichnungsschicht (B) ist mindestens ein Photopolymerisationsinitiator ($b_2$). Er liefert bei der Bestrahlung mit kurzwelligem aktinischem Licht, das ist UV-Licht, Radikale, welche die radikalische Polymerisation der Monomeren ($b_3$) und/oder der olefinisch ungesättigten Reste ($b_3$) initiieren und aufrechterhalten, was man auch als Photopolymerisation bezeichnet. In der neuen photopolymerisierbaren Aufzeichnungsschicht (B) sind die Photopolymerisationsinitiatoren ($b_2$) in einer Menge von 0,01 bis 10, vorzugsweise 0,1 bis 8 und insbesondere 0,5 bis 5 Gew.% enthalten.

Beispiele für geeignete Photopolymerisationsinitiatoren ($b_2$) sind Benzoin oder Benzoinderivate wie dessen Methyl-, Isopropyl-, N-Butyl- oder Isobutylether; symmetrisch oder unsymmetrisch substituierte Benzilacetale wie Benzildimethylacetal oder Benzil-1-methyl-1-ethyl-acetal; Acyldiarylphosphinoxide und Acylarylphosphinsäurederivate wie 2,6-Dimethoxybenzoyl-diphenylphosphinoxid, 2,4,6-Trimethylbenzoyl-diphenylphosphinoxid, 2,4,6-Trimethylbenzoylphenylphosphinsäure-Natriumsalz oder 2,4,6-Trimethylbenzoylphenylphosphinsäureethylester; oder substituierte oder unsubstituierte Chinone wie Ethylanthrachinon, Benzanthrachinon, Benzophenon oder 4,4′-Bis-(dimethylamino)-benzophenon. Sie können allein oder im Gemisch miteinander verwendet werden.

Darüber hinaus kann die neue photopolymerisierbare Aufzeichnungsschicht (B) noch weitere, übliche und bekannte Zusatzstoffe ($b_4$) wie Inhibitoren der thermischen Polymerisation, Weichmacher, Antistatika, Farbstoffe, Pigmente, photochrome Zusätze, Reduktionsmittel, Mittel zur Verbesserung der Reliefstruktur, Antioxidantien, Füllstoffe, Verstärkerfüllstoffe, Flußmittel, Formtrennmittel, Vernetzungshilfsmittel, klebrig machende Harze und Kautschuke enthalten. Diese üblichen und bekannten Zusatzstoffe ($b_4$) können für sich alleine oder als Gemische in Mengen von bis zu 50 Gew.% neben dem obligatorischen sensitometrischen Regler ($b_4$) in der neuen photopolymerisierbaren Aufzeichnungsschicht (B) enthalten sein.

Das erfindungsgemäße Aufzeichnungselement enthält mindestens eine der vorstehend im Detail beschriebenen neuen photopolymerisierbaren Aufzeichnungsschichten (B). Indes kann das erfindungsgemäße Aufzeichnungselement zwei, oder oder mehr dieser neuen photopolymerisierbaren Aufzeichnungsschichten (B) übereinanderliegend und haftfest miteinander verbunden enthalten, wobei die verwendeten neuen photopolymerisierbaren Aufzeichnungsschichten (B) von stofflich gleicher oder unterschiedlicher Zusammensetzung sein können. Daneben kann das erfindungsgemäße Aufzeichnungselement noch mindestens eine photopolymerisierbare Aufzeichnungsschicht bekannter Art enthalten. Erfindungsgemäß ist es von Vorteil, wenn das erfindungsgemäße Aufzeichnungselement nur eine neue photopolymerisierbare Aufzeichnungsschicht (B) enthält.

Der weitere wesentliche Bestandteil des erfindungsgemäßen Aufzeichnungselements ist der dimensionsstabile Träger (A). Beispiele geeigneter dimensionsstabiler Träger (A) sind Platten, Folien oder konische oder zylindrische Hülsen (sleeves) aus Metallen wie Stahl, Aluminium, Kupfer oder Nickel oder aus Hochpolymeren wie Polyethylenterephthalat, Polybutylenterephthalat, Polyamid oder Polycarbonat. Daneben kommen noch Gewebe und Vliese wie Glasfasergewebe oder Verbundmaterialien aus z.B. Glasfasern und Hochpolymeren wie z.B. Polyethylenterephthalat in Betracht.

Neben diesen beiden wesentlichen Bestandteilen, dem dimensionsstabilen Träger (A) und der neuen photopolymerisierbaren Aufzeichnungsschicht (B), kann das erfindungsgemäße Aufzeichnungselement weitere Schichten enthalten, die für seine Funktion von Nutzen sind. Bei diesen weiteren Schichten kann es sich z.B. um eine Haftlackschicht handeln, welche den dimensionsstabilen Träger (A) mit der neuen photopolymerisierbaren Aufzeichnungsschicht (B) haftfest verbindet. Beispiele besonders gut geeigneter Haftlackschichten werden in der deutschen Patentanmeldung P 37 19 844.0 beschrieben. Außerdem kann die freie Seite der neuen photopolymerisierbaren Aufzeichnungsschicht (B) des erfindungsgemäßen Aufzeichnungselements mit einer Deckschicht (C) und/oder mit einer Deckfolie (D) bedeckt werden.

Beispiele geeigneter Deckschichten (C) sind 0,5 bis 20 μm dick und bestehen aus einem Polymeren, welches lösliche, klebfreie, transparente und reißfeste Filme bildet, z.B. Polyamid, Copolyamid, Polyurethan, Polyvinylalkohol, Polyvinylpyrrolidon, Polyethylenoxid oder Cyclokautschuk mit einem hohen Cyclisierungsgrad. Gegebenenfalls kann die Deckschicht (C) mattiert sein.

Beispiele bekannter Deckfolien (D) sind 20 bis 150 μm dick und bestehen aus einem Polymeren wie Polyamid oder Polyethylenterephthalat. Auf der Seite, welcher der Deckschicht (C) oder der neuen photopolymerisierbaren Aufzeichnungsschicht (B) zugewandt ist, können sie übliche und bekannte, 0,1 bis 0,5 μm dicke Antihaftschichten aus z.B. Silikonharzen aufweisen. Gegebenenfalls kann die Deckfolie (D) mattiert sein.

Bei gemeinsamer Verwendung der Deckschicht (C) und der Deckfolie (D) liegt die Deckschicht (C) der neuen photopolymerisierbaren Aufzeichnungsschicht (B) direkt auf. Hierbei wird in üblicher und bekannter Weise die stoffliche Zusammensetzung von (C) und (D) so gewählt, daß die Deckschicht (C) an der neuen photopolymerisierbaren Aufzeichnungsschicht (B) fester haftet als an der Deckfolie (D), so daß letztere in einfacher Weise von dem erfindungsgemäßen Aufzeichnungselement abgezogen werden kann, ohne dieses hierbei zu beschädigen.

Enthält das erfindungsgemäße Aufzeichnungselement als dimensionsstabilen Träger (A) eine stark reflektierende Platte oder Folie, dann kann diese übliche und bekannte Lichthofschutzmittel wie Ruß oder Mangandioxid enthalten. Die Lichthofschutzmittel können aber auch als separate Schicht dem dimensionsstabilen Träger (A) aufliegen oder in der Haftlackschicht oder der neuen photopolymerisierbaren Aufzeichnungsschicht (B) selbst enthalten sein.

Die Herstellung des erfindungsgemäßen Aufzeichnungselements weist keine methodischen Besonderheiten auf, sondern erfolgt nach den üblichen und bekannten Methoden, wie sie für die Herstellung von lichtempfindlichen Aufzeichnungselementen allgemein verwendet werden. Üblicherweise geht die Herstellung des erfindungsgemäßen Aufzeichnungselements aus von der Herstellung der neuen photopolymerisierbaren Aufzeichnungsschicht (B). Hierzu werden deren Bestandteile ($b_1$), ($b_2$), ($b_3$) und ($b_4$) mit Hilfe der üblichen Knet-, Misch- und Lösungstechniken miteinander vermischt, so daß ein neues photopolymerisierbares Gemisch (B) resultiert. Dies wird dann in üblicher Weise durch Gießen aus einer Lösung, Heißpressen, Kalandrieren oder Extrudieren zu der neuen photopolymerisierbaren Aufzeichnungsschicht (B) der gewünschten Dicke geformt. Die Dicke richtet sich in erster Linie nach dem Verwendungszweck des erfindungsgemäßen lichtempfindlichen Aufzeichnungselements. Wird dieses, wie es erfindungsgemäß von ganz besonderem Vorteil ist, für die Herstellung von Reliefdruckplatten oder Photoresisten verwendet, liegt die Dicke seiner neuen photopolymerisierbaren Aufzeichnungsschicht (B) vorzugsweise bei 1 $\mu$m bis 0,5 cm. Hierbei kann die neue photopolymerisierbare Aufzeichnungsschicht (B) direkt auf die Oberfläche des dimensionsstabilen Trägers (A) oder auf die Oberfläche der auf dem Träger (A) befindlichen Haftlackschicht aufgetragen werden, wonach ihre freie Seite mit der Deckschicht (C) und/oder mit der Deckfolie (D) verbunden wird. Es ist aber auch möglich, die neue photopolymerisierbare Aufzeichnungsschicht (B) zuerst auf die mit der Deckschicht (C) bedeckte Oberfläche der Deckfolie (D) aufzutragen und anschließend die freie Oberfläche der photopolymerisierbaren Aufzeichnungsschicht (B) mit dem dimensionsstabilen Träger (A) gegebenenfalls über eine Haftlackschicht haftfest zu verbinden.

Aus dem erfindungsgemäßen Aufzeichnungselement können in üblicher und bekannter Weise photopolymerisierte Reliefdruckplatten und Photoresiste hergestellt werden, welche eine neue Relfiefschicht (B′) enthalten. Ihre Herstellung bietet keine methodischen Besonderheiten, sondern erfolgt - gegebenenfalls nach einer Vorbehandlung - durch bildmäßiges Belichten des erfindungsgemäßen Aufzeichnungselements mit kurzwelligem aktinischem Licht einer Wellenlänge $\lambda$ zwischen 300 und 450 nm, vorteilhafterweise zwischen 320 und 400 nm, durch eine aufgelegte Negativvorlage hindurch, gefolgt von dem Auswaschen der unbelichteten und daher nicht photopolymerisierten Bereiche der bildmäßig belichteten Aufzeichnungsschicht (B) mit einem geeigneten Entwicklerlösungsmittel, wodurch die neue Reliefschicht (B′) resultiert. Üblicherweise wird diese nach ihrer Herstellung getrocknet.

Beispiele üblicher Vorbehandlungen sind das Abziehen der gegebenenfalls in dem erfindungsgemäßen Aufzeichnungselement vorhandenen Deckfolie (D) und die vollflächige Belichtung der neuen photopolymerisierbaren Aufzeichnungsschicht (B) und/oder der gegebenenfalls vorhandenen Haftlackschicht mit aktinischem Licht von der Rückseite und/oder von der Vorderseite her.

Geeignete Lichtquellen für aktinisches Licht sind z.B. handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Beispiele geeigneter Entwicklerlösungsmittel sind Wasser, wäßrig-alkoholische Lösungen oder wäßrig-alkalische Lösungen, welche geeignete Additive wie z.B. Tenside enthalten können.

Nach dem Trocknen kann die neue Reliefschicht (B′) einer üblichen Nachbehandlung wie z.B. dem vollflächigen Nachbelichten mit aktinischem Licht unterzogen werden.

Die Dicke der neuen Reliefschicht (B′) variiert je nach Verwendungszweck vorteilhafterweise von 1 $\mu$m bis 0,5 cm.

Die in dieser Weise erhaltenen Reliefdruckplatten können in üblicher Weise auf Druckzylinder aufgebracht und für den Endlosdruck verwendet werden. Die in dieser Weise erhaltenen Photoresiste können der Herstellung von elektrischen Schaltungen in Leiterplatten dienen.

Das erfindungsgemäße Aufzeichnungselement erweist sich bei der vorstehend beschriebenen Herstellung von Reliefdruckplatten und Photoresisten als

- besonders rasch belichtbar, wobei sein Belichtungsspielraum ausgesprochen groß ist,
- detailgetreu in der Wiedergabe auch der kritischen feinsten Bildmotive der Negativvorlage, wobei die

resultierende Reliefdruckplatte oder der resultierende Photoresist außerdem noch eine hervorragende Relieffeinstruktur aufweist, die sich insbesondere an den Zwischentiefen bemerkbar macht, und als

- ausgesprochen auswaschstabil, so daß die Entwicklungsbedingungen zwecks Verkürzung der Entwicklungszeiten bedenkenlos verschärft werden können.

Dadurch verkürzen sich die Taktzeiten bei der Herstellung von Reliefdruckplatten und Photoresisten, was für die betriebliche Praxis ein erheblicher Vorteil ist. Dieser Vorteil fällt insbesondere bei der Herstellung von Reliefdruckplatten ins Gewicht.

Die besonderen Vorteile des erfindungsgemäßen Aufzeichnungselements sind damit nicht ausgeschöpft, sondern sie manifestieren sich besonders überzeugend in den Reliefdruckplatten und den Photoresisten sowie bei deren Verwendung: So liefern die aus den erfindungsgemäßen Aufzeichnungselementen hergestellten Reliefdruckplatten exzellente Drucke in besonders hoher Auflage, und die Verwendung der Photoresiste führt zu einer Erniedrigung der Ausschußrate bei der Herstellung elektrischer Leiterplatten.

Beispiele

In den folgenden Beispielen und Vergleichsversuchen wurde bei der Belichtung der erfindungsgemäßen und nicht erfindungsgemäßen Aufzeichnungselemente ein übliches und bekanntes Standard-Negativ verwendet. Die Messung der Zwischentiefen in den Reliefdruckplatten, welche aus den erfindungsgemäßen und den nicht erfindungsgemäßen Aufzeichnungselementen hergestellt wurden, erfolgte in üblicher und bekannter Weise visuell mit Hilfe eines Mikroskops. Hierbei wurden in den Beispielen 1 bis 8 und in den Vergleichsversuchen V1 und V2 die Zwischentiefen für Raster des Tonwerts 50 % bei 60 Linien/cm Auflösung [= $t_z$ (50)] sowie die Zwischentiefe in einem negativen Punkt von 0,4 mm Durchmesser (= $t_{NP}$) in µm gemessen. Darüber hinaus wurde die Gesamtqualität der Reliefschichten (B′) der Reliefdruckplatten beurteilt. Wesentliche Kriterien hierfür waren

- sauber ausgebildete, steile Reliefflanken, welche frei von Unterwaschungen waren,
- gerade Reliefkanten, welche frei von Kantenausbrüchen waren, und
- sehr gut ausgeprägte Zwischentiefen.

Nach der visuellen Beurteilung der Reliefschichten (B′) der Druckplatten wurden diese auf Druckzylinder aufgespannt und für den Endloshochdruck verwendet. Hierbei kamen die für die Hochdrucktechnik üblichen und bekannten Hochdruckmaschinen sowie die entsprechenden typischen, üblichen und bekannten Hochdruckfarben zur Anwendung. Entscheidendes Qualitätskriterium für die jeweils verwendete Druckplatte war die hiermit erreichbare Auflage exzellenter Drucke.

Beispiele 1 bis 7 und Vergleichsversuch V1

Die Herstellung erfindungsgemäßer (Beispiele 1 bis 7) und nicht erfindungsgemäßer (Vergleichsversuch V1) Aufzeichnungselemente und ihre Verwendung zur Herstellung von Druckplatten; allgemeine Herstellvorschrift:

Aus den jeweiligen Bestandteilen ($b_1$), ($b_2$), ($b_3$) und ($b_4$) der betreffenden photopolymerisierbaren Aufzeichnungsschichten wurden bei 60°C 50 %ige Lösungen in einem Gemisch aus Wasser und Methanol im Gewichtsverhältnis von 40:60 hergestellt.

Die jeweiligen Lösungen wurden auf Polyethylenterephthalat-Deckfolien (D) ausgegossen, so daß nach dem Verdampfen der Lösungsmittel bei Raumtemperatur photopolymerisierbare Aufzeichnungsschichten von 0,5 mm Dicke resultierten. Die so erhaltenen photopolymerisierbaren Aufzeichnungsschichten wurden unter Verwendung eines Gemisches aus Ethanol und Wasser im Volumenverhältnis 1:1 über die in der deutschen Patentanmeldung P 38 08 952.1 beschriebenen Haftlackschichten mit 0,2 mm dicken Polyethylenterephthalatfolien (A) haftfest verbunden.

Hiernach wurden die Polyethylenterephthalat-Deckfolien (D) abgezogen. Anschließend wurden die photopolymerisierbaren Aufzeichnungsschichten mit Standard-Negativen bedeckt und in einem handelsüblichen Belichter mit Leuchtstoffröhren (Emissionsmaximum bei $\lambda$ = 350 nm) während 3 Minuten mit aktinischem Licht bildmäßig belichtet, anschließend in einem handelsüblichen Sprühwascher bei 40°C und einem Wasserdruck von 4 bar während 3 Minuten entwickelt und danach getrocknet.

Die Reliefschichten (B′) der in dieser Weise erhaltenen Reliefdruckplatten wurden visuell beurteilt, wonach die Reliefdruckplatten auf Druckzylinder aufgespannt und für den Endloshochdruck verwendet wurden.

Die Tabelle 1 gibt Auskunft über die stoffliche Zusammensetzung der in der vorstehend angegebenen Weise hergestellten und weiterverarbeiteten photopolymerisierbaren Aufzeichnungsschichten. Die Ergebnisse der visuellen Beurteilung der Reliefschichten (B′) ist in Tabelle 2 im Überblick dargestellt.

In der Tabelle 1 haben die Abkürzungen die folgenden Bedeutungen:

| | |
|---|---|
| ($b_{11}$) | Vinylalkohol-Ethylenoxid-Pfropfmischpolymerisat eines Ethylenoxidgehalts von 40 Gew.% und eines massenmittleren Molekulargewichts $\overline{M}_w$ von $3{,}5 \cdot 10^4$ gemäß EP-A-0 224 164; |
| ($b_{21}$) | Benzildimethylacetal; |
| ($b_{31}$) | 2-Hydroxy-3-phenoxypropylacrylat; |
| RF | Riboflavin; |
| RFTB | Riboflavin-tetrabutyrat und |
| FMN | Flavinmononucleotid. |

Tabelle 1: Stoffliche Zusammensetzung der erfindungsgemäßen photopolymerisierbaren Aufzeichnungsschichten (B) (Beispiele 1 bis 7) und der nicht erfindungsgemäßen Aufzeichnungsschicht (Vergleichsversuch V1)

| Bsp. Nr. | Bestandteile $b_1$ (Gew.%) | $b_2$ (Gew.%) | $b_3$ (Gew.%) | sensitometrischer Regler $b_4$: $b_{41}$ (Gew.%) | $b_{42}$ (Gew.%) | Gewichtsverhältnis $b_{41} : b_{42}$ |
|---|---|---|---|---|---|---|
| 1 | $b_{11}$ (53,911) | $b_{21}$ (1,47) | $b_{31}$ (44,1) | RFTB (0,029) | N-Nitrosocyclohexyl-hydroxylamin-Kaliumsalz (0,49) | 1:16 |
| 2 | $b_{11}$ (53,911) | $b_{21}$ (1,47) | $b_{31}$ (44,1) | RFTB (0,029) | Hydrochinonmono-methylether (0,49) | 1:16 |
| 3 | $b_{11}$ (53,911) | $b_{21}$ (1,47) | $b_{31}$ (44,1) | FMN-Natriumsalz (0,029) | N-Nitrosocyclohexyl-hydroxylamin-Kaliumsalz (0,49) | 1:16 |
| 4 | $b_{11}$ (53,9251) | $b_{21}$ (1,47) | $b_{31}$ (44,11) | RF (0,0049) | N-Nitrosocyclohexyl-hydroxylamin-Kaliumsalz (0,49) | 1:100 |
| 5 | $b_{11}$ (53,9124) | $b_{21}$ (1,47) | $b_{31}$ (44,108) | Alloxazin (0,0196) | N-Nitrosocyclohexyl-hydroxylamin-Kaliumsalz (0,49) | 1:25 |

Tabelle 1 (Fortsetzung)

| Bsp. Nr. Bsp. | Bestandteile $b_1$ (Gew.%) | $b_2$ (Gew.%) | $b_3$ (Gew.%) | sensitometrischer Regler $b_4$: $b_{41}$ (Gew.%) | $b_{42}$ (Gew.%) | Gewichtsverhältnis $b_{41}$ : $b_{42}$ |
|---|---|---|---|---|---|---|
| 6 | $b_{11}$ (53,9124) | $b_{21}$ (1,47) | $b_{31}$ (44,108) | 7,8-Dimethyl-alloxazin (0,0196) | N-Nitrosocyclohexyl-hydroxylamin-Kaliumsalz (0,49) | 1:25 |
| 7 | $b_{11}$ (53,9124) | $b_{21}$ (1,47) | $b_{31}$ (44,108) | 7,8,9-Tri-methyliso-alloxazin (0,0196) | N-Nitrosocyclohexyl-hydroxylamin-Kaliumsalz (0,49) | 1:25 |
| V1 | $b_{11}$ (53,923) | $b_{21}$ (1,47) | $b_{31}$ (44,117) | - | N-Nitrosocyclohexyl-hydroxylamin-Kaliumsalz (0,49) | - |

Tabelle 2: Versuchsergebnisse

| Bsp. Nr. | Belichtungs-zeit (min) | Zwischentiefen $t_Z$ (50) (µm) | Zwischentiefen $t_{NP}$ (µm) | Reliefqualität Reliefflanken | Reliefqualität Reliefkanten |
|---|---|---|---|---|---|
| 1 | 3 | 42 | 170 | steil, glatt | gerade |
| | 6 | 41 | 180 | steil, glatt | gerade |
| 2 | 3 | 36 | 92 | steil, glatt | gerade |
| | 6 | 32 | 70 | steil, glatt | gerade |
| 3 | 3 | 43 | 175 | steil, glatt | gerade |
| | 6 | 35 | 184 | steil, glatt | gerade |
| 4 | 3 | 21 | 70 | steil, glatt | gerade |
| | 6 | 20 | 80 | steil, glatt | gerade |
| 5 | 3 | 30 | 147 | steil, glatt | gerade |
| | 6 | 27 | 130 | steil, glatt | gerade |
| 6 | 3 | 30 | 129 | steil, glatt | gerade |
| | 6 | 28 | 132 | steil, glatt | gerade |
| 7 | 3 | 48 | 195 | steil, glatt | gerade |
| | 6 | 45 | 226 | steil, glatt | gerade |

Tabelle 2: (Fortsetzung)

| Bsp. Nr. | Belichtungszeit (min) | Zwischentiefen $t_Z$ (50) (µm) | $t_{NP}$ (µm) | Reliefqualität Reliefflanken | Reliefkanten |
|---|---|---|---|---|---|
| Vergl. Versuch | | | | | |
| V1 | 3 | 21 | 41 | flach, | mit Ausbrüchen |
| | 6 | 22 | 28 | flach, | mit Ausbrüchen |

Die in der Tabelle 2 zusammengestellten Ergebnisse der Versuche belegen, daß der erfindungsgemäß zu verwendende sensitometrische Regler ($b_4$) eine deutliche Verbesserung der Relieffeinstruktur bei den Reliefdruckplatten bewirkt, welche aus den erfindungsgemäßen photopolymerisierbaren Aufzeichnungsschichten (B) (Beispiele 1 bis 7) hergestellt wurden. Darüber hinaus wurde auch noch eine sehr hohe Auflage an exzellenten Drucken beim Endlosdruck erzielt, ohne daß der Druckvorgang unterbrochen werden mußte, um die Druckplatten zu säubern.

Beispiel 8 und Vergleichsversuch V2

Herstellung und Weiterverarbeitung eines erfindungsgemäßen Aufzeichnungselements (Beispiel 8) und

eines nicht erfindungsgemäßen Aufzeichnungselements (Vergleichsversuch V2); Versuchsvorschrift:

Nach der bei den Beispielen 1 bis 7 angegebenen allgemeinen Versuchsvorschrift wurde unter Verwendung von 80°C heißen Lösungsmittelgemischen aus Wasser und n-Propanol im Gewichtsverhältnis von 3:1 das erfindungsgemäße Aufzeichnungselement des Beispiels 8 und das nicht erfindungsgemäße Aufzeichnungselement des Vergleichsversuchs V2 hergestellt.

Die photopolymerisierbare Aufzeichnungsschicht beider Aufzeichnungselemente war 0,5 mm dick.

Die neue photopolymerisierbare Aufzeichnungsschicht (B) des Beispiels 8 bestand aus

| | |
|---|---|
| 26 Gew.% | des handelsüblichen Vinylalkohol-Ethylenoxid-Pfropfmischpolymerisats Mowiol® 04-M1 der Fa. Hoechst AG, |
| 41,808 Gew.% | eines partiell hydrolysierten Polyvinylacetats eines Hydrolysegrades von 80 % und eines Polymerisationsgrades von 400; die freie Hydroxylgruppen waren zu 4 Mol.% mit Methacrylsäure verestert worden, |
| 30,462 Gew.% | Butan-1,4-diol-diglycidyletherdiacrylat, |
| 1,2 Gew.% | Benzildimethylacetal, |
| 0,5 Gew.% | N-Nitrosocyclohexylhydroxylamin-Kaliumsalz ($b_{42}$) und |
| 0,03 Gew.% | Riboflavin-tetrabutyrat ($b_{41}$). |

Die photopolymerisierbare Aufzeichnungsschicht des nicht erfindungsgemäßen Aufzeichnungselements des Vergleichsversuchs V2 bestand aus

| | |
|---|---|
| 26,08 Gew.% | des Pfropfmischpolymerisats des Beispiels 8, |
| 41,734 Gew.% | des Polyvinylalkohols des Beispiels 8, |
| 30,486 Gew.% | des Monomeren des Beispiels 8, |
| 1,2 Gew.% | des Photopolymerisationsinitiators des Beispiels 8 und |
| 0,5 Gew.% | N-Nitrosocyclohexylhydroxylamin-Kaliumsalz ($b_{42}$). |

Aus diesen beiden Aufzeichnungselementen wurden nach der bei den Beispielen 1 bis 7 angegebenen Versuchsvorschrift Reliefdruckplatten hergestellt. Hierbei lag die Belichtungszeit generell bei 6 Minuten.

Das erfindungsgemäße Aufzeichnungselement des Beispiels 8 lieferte eine Reliefschicht (B') mit ausgezeichnet ausgebildeter Reliefstruktur. Die Zwischentiefe $t_z$ lag bei 55 µm, die Zwischentiefe $t_{NP}$ bei 235 µm. Die Reliefflanken waren steil und glatt, die Reliefkanten gerade und ohne Ausbrüche. Beim Drucken auf einem Hochdruckwerk lieferte die Reliefdruckplatte exzellente Drucke in der hohen Auflage von 200.000.

Demgegenüber war die Reliefstruktur der aus dem bekannten Aufzeichnungselement hergestellten Reliefschicht weniger gut ausgeprägt. So lagen die Zwischentiefen $t_z$ bei 24 µm Zwischentiefen $t_{NP}$ bei 34 µm. Außerdem waren die Reliefflanken weniger steil und z.T. leicht unterwaschen. Bei den Reliefkanten traten stellenweise Ausbrüche auf.

Diese Versuchsergebnisse untermauern erneut die vorteilhafte technische Wirkung des erfindungsgemäß zu verwendenden sensitometrischen Reglers ($b_4$).

Beispiel 9 und Vergleichsversuche V3 und V4

Herstellung und Weiterverarbeitung eines erfindungsgemäßen Aufzeichnungselements (Beispiel 9) sowie nicht erfindungsgemäßer Aufzeichnungselemente (Vergleichsversuch V3 und V4); Versuchsvorschrift:

Für das Beispiel 9 wurden 50 Gew.-Teile eines partiell verseifen Polyvinylacetats (Hydrolysegrad 82 %, durchschnittlicher Polymerisationsgrad c.a. 500) und 20 Gew.-Teile eines partiell hydrolysierten Vinylacetat-Ethylenoxid-Pfropfmischpolymerisats eines Ethylenoxidgehaltes von 22 Gew.%, eines durchschnittlichen massenmittleren Molekulargewichts $\overline{M}_w$ von $2{,}5 \cdot 10^4$ bis $3 \cdot 10^4$ und eines Hydrolysegrades von 82 % bei 90°C in 70 Gew.-Teilen Wasser gelöst. Nach dem Abkühlen der resultierenden Lösungen auf 70°C wurden 10 Gew.-Teile Butan-1,4-dioldimethacrylat, 53 Gew.-Teile 2-Hydroxyethylmethacrylat, 1 Gew.-Teil 2,4,6-Trimethylbenzoyl-diphenylphosphinoxid, 0,01 Gew.-Teile Hydrochinon, 0,01 Gew.-Teile Hydrochinonmonomethylether ($b_{42}$), 0,014 Gew.-Teile Riboflavin ($b_{41}$) sowie 0,03 Gew.-Teile des weiteren milden Reduktionsmittels N-Nitrosodiphenylamin ($b_{42}$) eingerührt.

Bei dem Vergleichsversuch V3 wurde wie in Beispiel 9 verfahren, nur daß auf die Zugabe von Riboflavin ($b_{41}$) verzichtet wurde.

Bei dem Vergleichsversuch V4 wurde wie in Beispiel 9 verfahren, nur daß die Zugabe von Trimethylbenzoyl-diphenylphosphinoxid ($b_2$) unterblieb.

Nach dem Entgasen unter reduziertem Druck wurden die drei Lösungen auf Stahlbleche aufgetragen, welche mit einer lichthofschutzmittelhaltigen Schicht sowie mit einem üblichen und bekannten Haftlack bedeckt waren. Nach 24stündigem Belüften bei Raumtemperatur wurden drei lichtempfindliche Aufzeichnungselemente mit jeweils 0,5 mm dicken, klebfreien photopolymerisierbaren Aufzeichnungsschichten erhalten.

Diese drei lichtempfindlichen Aufzeichnungselemente wurden in einem eisendotierten Quecksilberbrenner während 2,5 Sekunden vollflächig vorbelichtet und hiernach während 30 Sekunden durch die Standard-Negativvorlage hindurch bildmäßig belichtet. Hierbei trat in der Aufzeichnungsschicht des Vergleichsversuchs V4 - selbst bei einer Verlängerung der Belichtungszeit auf über 10 min - keine Photopolymerisation ein. Es wurden deshalb nur die bildmäßig belichteten Aufzeichnungselemente des Beispiels 9 und des Vergleichsversuchs V3 in einem handelsüblichen Sprühwascher bei 40°C und einem Wasserdruck von 4 bar während 2,5 Minuten entwickelt und hiernach getrocknet.

An den Reliefschichten der in dieser Weise erhaltenen Reliefdruckplatten wurden die Zwischentiefen des negativen Punktes $t_{NP}$ sowie die Zwischentiefen der Raster einer Rasterweite von 24 Linien/cm und der Tonwerte 30 % [$t_z$ (30)], 50 % [$t_z$ (50)] und 70 % [$t_z$ (70)] gemessen. Zugleich wurde die Qualität der Reliefstruktur visuell beurteilt. Anschließend wurden die Reliefdruckplatten auf Druckzylinder aufgespannt und für den Endloshochdruck verwendet.

Die Ergebnisse dieser Versuche sind in der Tabelle 3 zusammengestellt.

Die Ergebnisse der Tabelle 3 zeigen, daß das erfindungsgemäße Aufzeichnungselement des Beispiels 9 dem nicht erfindungsgemäßen Aufzeichnungselement des Vergleichsversuchs V3 in jeder Hinsicht überlegen war.

Tabelle 3: Versuchsergebnisse

| Bsp. | Belichtungszeit (s) | Zwischentiefen Raster mit 24 Linien/cm) $t_Z$ (30) (µm) | $t_Z$ (50) (µm) | $t_Z$ (70) (µm) | $t_{NP}$ (µm) | Reliefqualität Reliefflanken, | Reliefkanten | Druckverhalten: Auflage exzellenter Drucke |
|---|---|---|---|---|---|---|---|---|
| 9 | 30 | 125 | 90 | 73 | 165 | steil | glatt | auch ohne Unterbrechung des Druckvorgangs hoch |
| Vgl.Vers. v3 | 30 | 68 | 39 | 28 | 65 | flach | mit Ausbrüchen | nur dann im üblichen Bereich, wenn der Druckvorgang unterbrochen und die Druckplattenoberfläche gesäubert wird |

## Patentansprüche

1. Lichtempfindliches Aufzeichnungselement für die Herstellung von Reliefdruckplatten und Photoresisten mit
   A) einem dimensionsstabilen Träger und mit
   B) mindestens einer photopolymerisierbaren Aufzeichnungsschicht aus
      $b_1$) mindestens einem partiell oder nahezu vollständig hydrolysierten Poly(vinylalkoholalkancarbonsäureester) und/oder mindestens einem partiell oder nahezu vollständig hydrolysierten Vinylalkoholalkancarbonsäureester-Alkylenoxid-Pfropfmischpolymerisat als Bindemittel,
      $b_2$) mindestens einem Photopolymerisationsinitiator, welcher beim Bestrahlen mit kurzwelligem aktinischem Licht Radikale liefert, die die Photopolymerisation initiieren,
      $b_3$) mindestens einer photopolymerisierbaren olefinisch ungesättigten Verbindung (Monomer), welche mit dem Bindemittel ($b_1$) verträglich ist, und/oder photopolymerisierbaren olefinisch ungesättigten Resten, welche seitenständig und/oder endständig mit dem Bindemittel ($b_1$) verknüpft sind, und
      $b_4$) mindestens zwei Hilfsstoffen,

   dadurch gekennzeichnet, daß seine photopolymerisierbare Aufzeichnungsschicht (B) als Hilfsstoffe ($b_4$) zumindest den sensitometrischen Regler ($b_4$) aus
   $b_{41}$) mindestens einer Verbindung aus der Klasse der Isoalloxazine und/oder aus der Klasse der Alloxazine und
   $b_{42}$) N-Nitrosocyclohexylhydroxylamin-Kaliumsalz, N-Nitrosodiphenylamin und/oder Hydrochinonmonomethylether

   in einer Menge von 0,01 bis 6 Gew.%, bezogen auf die photopolymerisierbare Aufzeichnungsschicht (B), enthält, wobei das Gewichtsverhältnis ($b_{41}$):($b_{42}$) bei 1:2 bis 1:1000 liegt.

2. Das lichtempfindliche Aufzeichnungselement nach Anspruch 1, dadurch gekennzeichnet, daß es als Hilfsstoffe ($b_{41}$) Alloxazin, in 3-, 5-, 6-, 7-, 8- und/oder 9-Stellung mit Alkylresten mono-, di-, tri-, tetra-, penta- oder hexasubstituierte Alloxazine und/oder Isoalloxazine, 6,7-Dimethyl-9-(D′-ribityl)-flavin (Riboflavin, RF), Riboflavin-tetrabutyrat (RFTB), Riboflavin-5′-phosphat (Flavinmononucleotid, FMN) und/oder das Natriumsalz von FMN enthält.

3. Das lichtempfindliche Aufzeichnungselement nach Anspruch 1 oder 2, dadurch gekennzeichnet, daß in dem sensitometrischen Regler ($b_4$) das Gewichtsverhältnis ($b_{41}$):($b_{42}$) bei 1:10 bis 1:100 liegt.

4. Verwendung von
   ($b_{41}$) Verbindungen aus der Klasse der Isoalloxazine und/oder aus der Klasse der Alloxazine sowie von
   ($b_{42}$) N-Nitrosocyclohexylhydroxylamin-Kaliumsalz N-Nitrosodiphenylamin und/oder Hydrochinonmonomethylether

   im Gewichtsverhältnis ($b_{41}$):($b_{42}$) von 1:2 bis 1:1000 als sensitometrische Regler in photopolymerisierbaren Aufzeichnungsschichten.

5. Verwendung von
   ($b_{41}$) Verbindungen aus der Klasse der Isoalloxazine und/oder aus der Klasse der Alloxazine sowie von
   ($b_{42}$) N-Nitrosocyclohexylhydroxylamin-Kaliumsalz, N-Nitrosodiphenylamin und/oder Hydrochinonmonomethylether

   im Gewichtsverhältnis ($b_{41}$): ($b_{42}$) von 1:2 bis 1:1000 als sensitometrische Regler in photopolymerisierbaren Aufzeichnungsschichten (B), welche
   $b_1$) mindestens einen partiell oder nahezu vollständig hydrolysierten Poly(vinylalkoholalkancarbonsäureester) und/oder mindestens ein partiell oder nahezu vollständig hydrolysiertes Vinylalkoholalkancarbonsäureester-Alkylenoxid-Pfropfmischpolymerisat als Bindemittel,
   $b_2$) mindestens einen Photopolymerisationsinitiator, welcher bei der Belichtung mit kurzwelligem aktinischem Licht Radikale liefert, die die Photopolymerisation initiieren, und
   $b_3$) mindestens eine photopolymerisierbare olefinisch ungesättigte Verbindung (Monomer), welche mit dem Bindemittel ($b_1$) verträglich ist, und/oder photopolymerisierbare olefinisch ungesättigte Reste, welche seitenständig und/oder endständig mit dem Bindemittel ($b_1$) verknüpft sind,

   enthalten.

6. Verfahren zur Herstellung von Reliefdruckplatten oder Photoresisten mit einer in ihrer Reliefstruktur verbesserten Reliefschicht (B′) aus lichtempfindlichen Aufzeichnungselementen durch
   (1) bildmäßiges Belichten der photopolymerisierbaren Aufzeichnungsschicht (B) von lichtempfindlichen Aufzeichnungselementen mit aktinischem Licht, wodurch die belichteten Bereiche photopolymerisiert werden, und
   (2) Auswaschen (Entwickeln) der unbelichteten Bereiche der bildmäßig belichteten Aufzeichnungsschicht (B) mit einem geeigneten Entwicklerlösungsmittel unter Erzeugung einer photopolymerisierten Reliefschicht (B′),

   dadurch gekennzeichnet, daß man hierbei ein lichtempfindliches Aufzeichnungselement gemäß einem der Ansprüche 1 bis 3 verwendet.

## Claims

1. A photosensitive recording element for the production of relief printing plates and photoresists, having
   A) a dimensionally stable substrate and
   B) at least one photopolymerizable recording layer comprising
      $b_1$) at least one partially or virtually completely hydrolyzed poly(vinyl alkane-carboxylate) and/or at least one partially or virtually completely hydrolyzed vinyl alkanecarboxylate/alkylene oxide graft copolymer as a binder,
      $b_2$) at least one photopolymerization initiator which, on exposure to short-wave length actinic light, provides free radicals which initiate the photopolymerization,
      $b_3$) at least one photopolymerizable olefinically unsaturated compound (monomer) which is compatible with the binder ($b_1$) and/or photopolymerizable olefinically unsaturated radicals which are bonded as pendant and/or terminal groups to the binder ($b_1$), and
      $b_4$) at least two assistants,

   wherein its photopolymerizable recording layer (B) contains, as assistants ($b_4$), at least the sensitometric regulator ($b_4$) comprising
   $b_{41}$) at least one compound selected from the class consisting of the isoalloxazines and/or from the class consisting of the alloxazines and
   $b_{42}$) the potassium salt of N-nitrosocyclohexylhydroxylamine, N-nitrosodiphenylamine and/or hydroquinone monomethyl ether,

   in an amount of from 0.01 to 6% by weight, based on the photopolymerizable recording layer (B), the weight ratio ($b_{41}$) : ($b_{42}$) being from 1 : 2 to 1 : 1000.

2. A photosensitive recording element as claimed in claim 1, which contains, as assistants ($b_{41}$), alloxazine, alloxazines which are mono-, di-, tri-, tetra-, penta- or hexa-substituted by alkyl in the 3, 5, 6, 7, 8 and/or 9 positions and/or isoalloxazines, 6,7-dimethyl-9-(D′-ribityl)-flavin (riboflavin RF), riboflavin tetrabutyrate (RFTB), riboflavin 5′-phosphate (flavin mononucleotide, FMN) and/or the sodium salt of FMN.

3. A photosensitive recording element as claimed in claim 1 or 2, wherein, in the sensitometric regulator the weight ratio ($b_{41}$) : ($b_{42}$) is from 1 : 10 to 1 : 100.

4. Use of
   ($b_{41}$) compounds selected from the class consisting of the isoalloxazines and/or from the class consisting of the alloxazines and of
   ($b_{42}$) the potassium salt of N-nitrosocyclohexylhydroxylamine, N-nitrosodiphenylamine and/or hydroquinone monomethyl ether

   in a weight ratio ($b_{41}$) : ($b_{42}$) of from 1 : 2 to 1 : 1000 as sensitometric regulators in photopolymerizable recording media.

5. Use of
   ($b_{41}$) compounds selected from the class consisting of the isoalloxazines and/or from the class consisting of the alloxazines and of
   ($b_{42}$) the potassium salt of N-nitrosocyclohexylhydroxylamine, N-nitrosodiphenylamine and/or hydroquinone monomethyl ether

   in a weight ratio ($b_{41}$) : ($b_{42}$) of from 1 : 2 to 1 : 1000 as sensitometric regulators in photopolymerizable recording layers (B) which contain

$b_1$) at least one partially or virtually completely hydrolyzed poly(vinyl alkanecarboxylate) and/or at least one partially or virtually completely hydrolyzed vinyl alkanecarboxylate/alkylene oxide graft copolymer as a binder,
$b_2$) at least one photopolymerization initiator which, on exposure to short-wave length actinic light, provides free radicals which initiate the photopolymerization, and
$b_3$) at least one photopolymerizable olefinically unsaturated compound (monomer) which is compatible with the binder ($b_1$) and/or photopolymerizable olefinically unsaturated radicals which are bonded as pendant and/or terminal groups to the binder ($b_1$).

6. A process for the production of a relief printing plate or photoresist having a relief layer (B′) improved in its relief structure, comprising a photosensitive recording element, by
(1) imagewise exposure of the photopolymerizable recording layer (B) of the photosensitive recording element to actinic light, with the result that the exposed parts are photopolymerized, and
(2) washing out (development) of the unexposed parts of the imagewise exposed recording layer (B) with a suitable developer with production of a photopolymerized relief layer (B′),
wherein a photosensitive recording element as claimed in any of claims 1 to 3 is used.

## Revendications

1. Elément d'enregistrement sensible à la lumière pour la préparation de plaques d'impression en relief et de photoréserves, ayant
A) un support stable en dimensions et
B) au moins une couche d'enregistrement photopolymérisable comprenant
$b_1$) au moins un poly(ester d'alcool vinylique et d'acide alcanecarboxylique) partiellement ou presque totalement hydrolysé et/ou au moins un copolymère greffé d'ester d'alcool vinylique et d'acide alcane-carboxylique-oxyde dralkylène partiellement ou presque totalement hydrolysé en tant que liant,
$b_2$) au moins un initiateur de photopolymérisation, qui fournit, lors d'un éclairement avec une lumière actinique de courte longueur d'onde, des radicaux qui initient la photopolymérisation,
$b_3$) au moins un composé (monomère) photopolymérisable à insaturations oléfiniques, qui est compatible avec le liant ($b_1$), et/ou des restes photopolymérisables à insaturations oléfiniques, qui sont reliés latéralement ou en fin de chaîne avec le liant ($b_1$), et
$b_4$) au moins deux adjuvants,
caractérisé en ce que sa couche d'enregistrement photopolymérisable (B) contient,en tant qu'adjuvants ($b_4$), au moins le régulateur sensitométrique ($b_4$) composé de
$b_{41}$) au moins un composé de la classe des isoalloxazines et/ou de la classe des alloxazines et
$b_{42}$) le sel de potassium de N-nitrosocyclohexylhydroxylamine, la N-nitrosodiphénylamine et/ou l'éther monométhylique d'hydroquinone,
en une quantité de 0,01 à 6% en poids, par rapport à la couche d'enregistrement photopolymérisable (B), tandis que le rapport pondéral ($b_{41}$):($b_{42}$) est de 1:2 à 1:1000.

2. Elément d'enregistrement sensible à la lumière selon la revendication 1, caractérisé en ce qu'il contient comme adjuvants ($b_{41}$) de l'alloxazine, des alloxazines et/ou isoalloxazines mono-, di-, tri-, tétra-, penta- ou hexasubstituées par des restes alkyle en position 3, 5, 6, 7, 8 et/ou 9, de la 6,7-diméthyl-9-(D′-ribityl)-flavine (riboflavine, RF), du tétrabutyrate de riboflavine (RFTB), du 5′-phosphate de riboflavine (flavine-mononucléotide, FMN) et/ou le sel de sodium de FMN.

3. Elément d'enregistrement sensible à la lumière selon l'une des revendications 1 ou 2, caractérisé en ce que, dans le régulateur sensitométrique ($b_4$), le rapport pondéral ($b_{41}$):($b_{42}$) est compris entre 1:10 et 1:100.

4. Utilisation de
($b_{41}$) composés de la classe des isoalloxazines et/ou de la classe des alloxazines, ainsi que de
($b_{42}$) sel de potassium de N-nitrosocyclohexylhydroxylamine, N-nitrosodiphénylamine et/ou l'éther monométhylique d'hydroquinone,
dans le rapport pondéral ($b_{41}$):($b_{42}$) de 1:2 à 1:1000, comme régulateur sensitométrique dans des couches d'enregistrement photopolymérisables.

**5.** Utilisation de

($b_{41}$) composés de la classe des isoalloxazines et/ou de la classe des alloxazines, ainsi que de

($b_{42}$) sel de potassium de N-nitrosocyclohexylhydroxylamine, N-nitrosodiphénylamine et/ou l'éther monométhylique d'hydroquinone,

dans le rapport pondéral ($b_{41}$):($b_{42}$) de 1:2 à 1:1000, comme régulateur sensitométrique dans des couches d'enregistrement photopolymérisables (B), qui contiennent

$b_1$) au moins un poly(ester d'alcool vinylique et d'acide alcanecarboxylique) partiellement ou presque totalement hydrolysé et/ou au moins un copolymère greffé d'ester d'alcool vinylique et d'acide alcanecarboxylique-oxyde d'alkylène partiellement ou presque totalement hydrolysé en tant que liant,

$b_2$) au moins un initiateur de photopolymérisation, qui fournit, lors d'un éclairement avec une lumière actinique de courte longueur d'onde, des radicaux qui initient la photopolymérisation, et

$b_3$) au moins un composé (monomère) photopolymérisable à insaturations oléfiniques, qui est compatible avec le liant ($b_1$), et/ou des restes photopolymérisables à insaturations oléfiniques, qui sont reliés latéralement ou en fin de chaîne avec le liant ($b_1$).

**6.** Procédé pour la préparation de plaques d'impression en relief ou photoréserves, ayant une couche de relief (B′) améliorée dans leur structure de relief, en éléments d'enregistrement sensibles à la lumière par

(1) éclairement,pour donner des images,de la couche d'enregistrement photopolymérisable (B) d'éléments d'enregistrement sensibles à la lumière, photopolymérisant ainsi les zones éclairées, et

(2) lavage (développement) des zones non éclairées de la couche d'enregistrement (B) éclairée pour donner des images avec un solvant de développement approprié pour former une couche en relief photopolymérisée (B′),

caractérisé en ce qu'on utilise pour ce faire un élément d'enregistrement sensible à la lumière selon l'une quelconque des revendications 1 à 3.